# EUROPEAN PATENT SPECIFICATION

(11) **EP 0 461 663 B1**
(45) Date of publication and mention of the grant of the patent: **16.04.1997**
(21) Application number: 91109750.9
(22) Date of filing: 14.06.1991
(51) Int. Cl.: G03F 7/00, H01L 21/027

(54) **Method of manufacturing a semiconductor device, including a step of forming a pattern on a photo-resist film**
Verfahren zum Herstellen einer Halbleitervorrichtung einschliesslich eines Herstellungsschrittes für ein Muster eines Fotoresistfilms
Méthode de fabrication d'un composant semiconducteur, incluant une étape de formation d'un motif en résine photosensible

(30) Priority: 14.06.1990 JP 156100/90
(43) Date of publication of application: 18.12.1991
(73) Proprietor: KABUSHIKI KAISHA TOSHIBA, Kawasaki-shi, Kanagawa-ken 210 (JP)
(72) Inventor: Tsuji, Hitoshi, c/o Intellectual Pty. Division, Minato-ku, Tokyo 105 (JP); Haraguchi, Hiroshi, c/o Intellectual Pty. Division, Minato-ku, Tokyo 105 (JP)
(74) Representative: Lehn, Werner, Dipl.-Ing.

(56) References cited:
- EP-A- 0 037 708
- EP-A- 0 192 302
- EP-A- 0 244 019
- EP-A- 0 282 201
- DE-A- 3 807 142
- GB-A- 2 203 564
- PATENT ABSTRACTS OF JAPAN vol. 12, no. 217 (E-624)(3064) 21 June 1988, & JP-A-63 012 156 (MITSUBISHI ELECTRIC CORP.) 19 January 1988
- MICROELECTRONIC ENGINEERING. vol. 11, no. 1/4, April 1990, AMSTERDAM NL pages 497 - 502; C.M.J. MUTSAERS et al.: "IMRE, BIM and SUPER using patternwise esterification"
- PATENT ABSTRACTS OF JAPAN vol. 14, no. 65 (E-884) 06 February 1990, & JP-A-01 283 829 (MITSUBISHI ELECTRIC CORP.) 15 November 1989
- PATENT ABSTRACTS OF JAPAN vol. 11, no. 331 (P-630)(2778) 29 October 1987, & JP-A-62 113 141 (FUJI ELECTRIC CO. LTD.) 25 May 1987
- PATENT ABSTRACTS OF JAPAN vol. 6, no. 25 (E-94)(903) 13 February 1982, & JP-A-56 144 539 (HITACHI SEISAKUSHO K.K.) 10 November 1981

## Description

The present invention relates to a process for forming an image and is applicable to a lithographical technique employed for manufacturing a semiconductor device, more specifically to an image reversal process during formation of a resist pattern.

Other pattern-forming methods are described in JP-A-62-113141, JP-A-1-28 38 29 and JP-A-56-144 539.

In the regular technique for reversing an image on a photo-resist employed in an image reversal process, for example, a positive resist film is deposited on a wafer, and then the first exposure is carried out by use of a mask, onto a selected portion of the resist film to form a pattern thereon. After that, the wafer is heat treated in an ammonia gas atmosphere at a temperature of 90°C or more, this step followed by the second exposure with ultraviolet rays irradiated onto the entire surface of the wafer.

The photo-resist film which have undergone the first and second exposures, and the heat treatment, is then developed, and a reversed image of the mask is thus obtained. The reason for the image being reversed is that the portion on the positive resist film exposed in the first exposure is not removed during the developing step, but the rest is removed during the developing step.

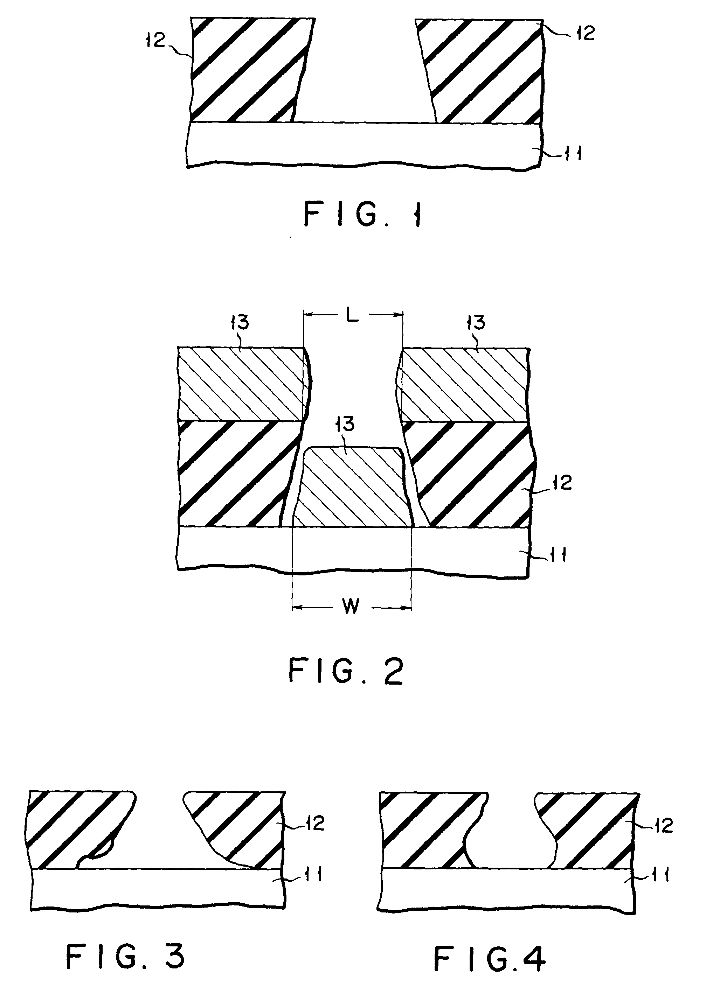

Fig. 1 of the accompanying drawings shows a profile of a developed resist pattern (to be called hereinafter a resist profile) made by an amount of exposure under a certain condition, obtained in the above-mentioned image reversal step, with a substrate 11 and a resist film 12 having a taper shape with the narrow top and the broad bottom.

In the meantime, the method of forming the image of a wire metal, in which a wiring metal is deposited on the entire surface of the resist film on which a resist pattern has been formed, and then the resist pattern is removed, is well-known as a lift-off method. According to the lift-off method, as can be seen in Fig. 2 of the accompanying drawings, a resist film 12 is formed on the surface of the substrate 11 by the image reversal treatment, and a metal film 13 is clad onto the entire surface of the substrate. Then, the resist film 12 is dissolved away, and at the same time, the metal layer located thereon is removed, thus forming a wiring metal pattern.

In this lift-off method, it is preferable that that portion of the metal film 13 which is located on the substrate 11, and that portion located on the resist film 12 should be separated from each other when the metal film 12 is being deposited on the entire surface of the substrate 11, as can be seen in Fig. 2. In this sense, a profile of the resist film should be formed into the above-mentioned taper shape. Since such a shape can be easily achieved by the image reversal treatment, Resist patternings are conducted, in many cases, through this treatment these days.

However, with this treatment, a desired tapered profile of the resist film 12 sometimes cannot be obtained under a certain circumstance due to over-corrosion as can be seen in Fig. 3, or residue of the resist remaining on the bottom of the opening of the resist film as shown in Fig. 4. If a desired tapered profile of the resist film 12 is not obtained as in the cases mentioned, formation of a wiring pattern to be conducted thereafter cannot be performed successfully, thereby decreasing the reliability of the product.

To solve such a problem, the inventors of the invention discovered an exposure amount with which a resist profile desirable for the lift-off process can be obtained, and carried out resist patternings by the above-mentioned image reversal treatment in the conventional manner. The results of the resist patternings were as shown in Tables 1 and 2, which exhibited that the diameter of an opening (dimension L in Fig. 2) and the dimension of a wiring metal (dimension W in Fig. 2) were greater than the designed dimension of a corresponding mask (mask dimension).

Table 1 shows measurements of the dimension L of the opening of the resist film obtained by the conventional image reversal treatment, in regard with the possible combinations between designed mask dimension of 0.6 µm, 0.8 µm, or 1.0 µm, against reagents A, B, C, and D. Further, Table 2 shows measurements of the dimension (width) W of the metal films formed by the lift-off method using the above resist film, in regard with the same combinations as in Table 1.

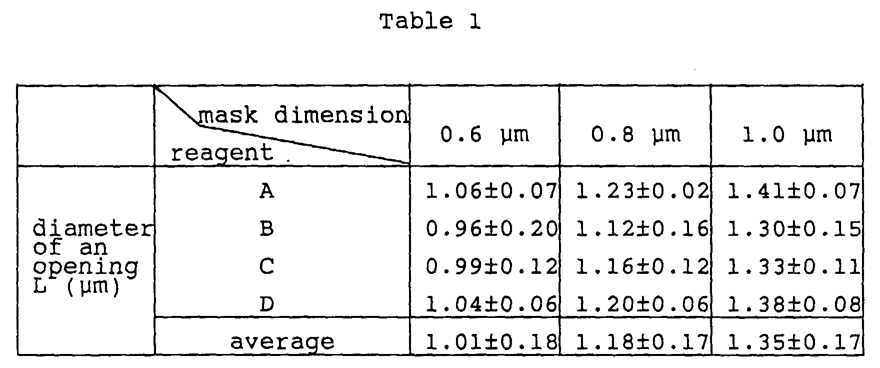

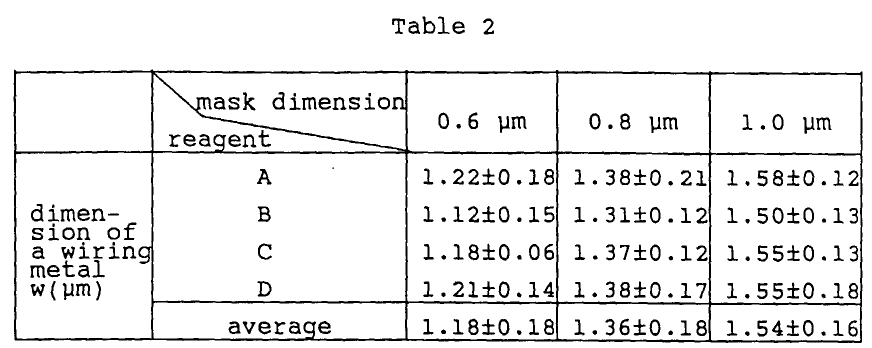

As understood from the results shown in Tables 1 and 2, it can be generalized that the diameter of the opening of a resist film is greater than the dimension of a corresponding mask by about 0.4 µm. Therefore, in order to obtain an opening of the resist film having a desired dimension, the mask dimension should be designed 0.4 µm smaller than the actual dimension. However, the minimum possible dimension unit being able to be taken in the field of manufacture of semiconductor devices is at present is about 1.0 µm, and therefore it is very difficult to form a mask having a dimension of 1.0 µm or less. In reality, it is almost impossible to form a fine pattern having a dimension of 1.0 µm or less.

As described so far, in order to successfully conduct the lift-off method, which is employed for forming a metal wiring pattern of a semiconductor device, the resist profile of a film should be shaped into a taper shape with the narrow top and broad bottom. In this sense, an image reversal treatment is carried out in advance.

However, when the resist patternings are carried out by the conventional image reversal treatment, problems such as over-corrosion of a taper-shaped portion of a resist, residue of a resist film remaining, etc. are created. Further, if the exposure amount is controlled to solve the above problems, achieving a desired taper shape for the lift-off step, then another problem rises such as that the diameter of the opening of a resist film becomes greater than a corresponding mask dimension.

An object of the invention is to provide a process of forming an image in which when a resist pattern is formed by an image reversal treatment, the resist profile obtained has a taper shape desirable for the lift-off step, and is of a size which is substantially the same as that of a corresponding mask dimension at the 1 : 1 ratio.

According to the invention, there is provided a process for forming an image, comprising:
the step of forming a positive resist film on a semiconductor substrate, the positive resist film containing a novolak resin;
a first selective exposing step for forming an image pattern on a selected first region of said resist film with irradiation light mainly comprising g-ray light having a wavelength of 436 nm;
a heat treatment step for heating said resist film after said first exposing step;
a second selective exposing step for exposing said resist film with irradiation light mainly comprising g-ray light having a wavelength of 436 nm to form an image pattern on a selected second region of said resist film;
a first developing step for developing said resist film to remove a region of said resist film exposed in said second selective exposing step and not exposed in said first exposing step;
a third exposing step for exposing the entire surface of said resist film; and
a second developing step for developing said resist film to remove the resist film except for a region exposed in said first selective exposing step.

This invention can be more fully understood from the following detailed description when taken in conjunction with the accompanying drawings, in which:
Figs. 1 and 2 are cross sections of resist films illustrated for explanation of a lift-off method;
Figs. 3 and 4 are cross sections illustrated for explanation of problems arising through the conventional method;
Figs. 5 and 6 are graphs showing absorbances of different resists;
Figs. 7A to 7D are cross sections of a resist film at the steps of the first embodiment method according to the present invention;
Fig. 8 is a graph showing the distribution of the diameters of the openings formed in the resists of the semiconductor devices manufactured by the first embodiment method; and
Figs. 9A to 9D are cross sections of a resist film at the steps of the second embodiment method according to the present invention.

Embodiments of the present invention will now be described in detail with reference to accompanying drawings.

In usual image reversal treatments, the dissolubility of that portion of the film which is exposed to an irradiation against a developing solution, in the case of a positive resist, become less than that of the other portion, which was not exposed, after the first exposing step for forming an image pattern on a resist film, which step is followed by a heat treatment. Meanwhile, the dissolubility of the portion which was not exposed in the first exposing step is made higher after the second exposing step. Therefore, when the resist film is developed after the second exposing step, the portion exposed in the first exposing step remains as it is, and the unexposed portion is removed. Thus, a negative image reversed from a positive one can be obtained.

The resists treated in the image reversal treatments are generally divided into two types. The first type is that used in a heat treatment method conducted in an ammonia gas atmosphere, such as novolak-type positive resists. The other type is that in which reversal of an image can be easily achieved by a heat treatment, for example, novolak-type positive resist containing amines from the initial stage.

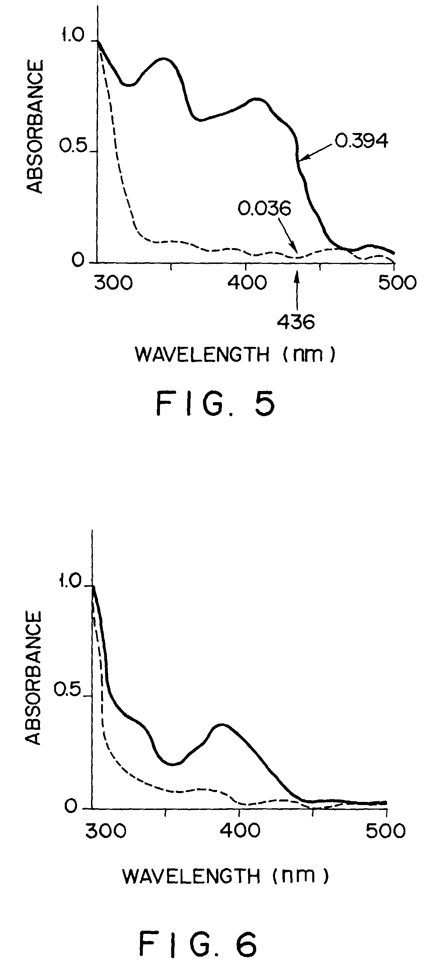

Fig. 5 shows the absorbance characteristics of "NPR820DX" produced by Nagase Sangyo Co., a novolak-type positive resist which can be heat treated in an ammonia gas atmosphere, and Fig. 6 depicts the absorbance characteristics of "AZ5200E" produced by Hexst Co., a novolak-type positive resists containing amines.

In each of the graphs shown in Figs. 5 and 6, the ordinate indicates relative absorbance in the case where the absorbance obtained is 1.0 when the wavelength of the light irradiated is 300nm, and the abscissa indicates wavelength (nm) of the rays contained in the irradiation light. Further, in each of the graphs, the continuous curve indicates the absorbance of the photo-resist before the exposure, whereas the broken curve indicates the absorbance thereafter.

From Figs. 5 an 6, it is understood that both resists tend to be photo-sensitized heavily when the wavelength of the irradiation light is 400nm or shorter, but with the irradiation having a wavelength same as that of the g ray (436nm) or longer, the absorbances of both resists do not vary regardless of before and after the exposure.

In the first exposing step for forming an image pattern, a step-and-repeat type exposing device (stepper) is used in many cases to enhance the accuracies of fine patterning and alignment of the pattern. The present invention employs the above-mentioned well-known technique as the first exposing step.

In the second exposing step of the conventional method, the entire surface of a resist is exposed with an amount of irradiation with which the variable density is suppressed as much as possible by, for example, a flat exposing device , so as to maximise throughput. The irradiation light used in this step is of the type which includes a variety of rays having wavelengths covering from long ones such as that of g ray (436nm), through that of i ray (365nm), to even 300nm or shorter, for example that of a mercury lamp.

The inventors of the present invention discovered that the aforementioned problems can be solved by exposing the entire surface of the resist in the second exposing step by a stepper which emits g rays. The invention has been achieved based on this discovery after a number of trials designed to ensure satisfactory results.

In the present invention, the irradiation light used in the first exposing step is defined as ultraviolet rays having wavelengths such as of g ray or longer, with which the absorbance of the resist varies only a little between before and after of an exposure, that is, the resist does not become too reactive. The appropriate amount of exposure, using such irradiation light, is applied onto the resist and thus the desired taper-shaped cavity is formed in the resist. With this procedure, the 1 : 1 ratio of the diameter of the opening of the resist to the corresponding mask dimension is stably obtained. In this case, it is preferable to use a filter which transmits the g rays on the light source of the flat exposure, or a stepper the exposure light of which mainly contains the g rays.

Various embodiments of the present invention will now be explained.

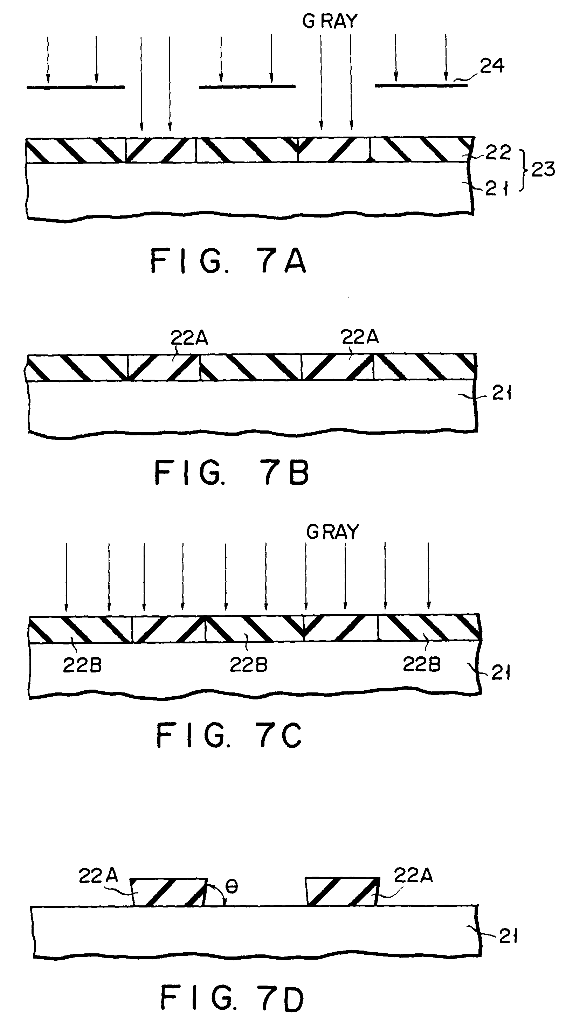

Figs. 7A to 7D are the diagrams of cross sections illustrated to explain the method according to the present invention in the case where the method is applied to formation of a resist pattern used in the lift-off method.

Fig. 7A, which is designed for explaining the first exposing step, shows a wafer 23 prepared by applying a novolak-type positive resist, for example, "NPR820DX" produced by Nagase Sangyo Co., by the conventional method, to form a resist film 22 on a GaAs substrate 21. In this figure, the resist is applied directly onto the GaAs substrate 21, but the resist may be applied indirectly to the substrate via an interlayer insulation film deposited therebetween. After that, a selected portion of the resist film 22 is exposed, using a mask 24, to the g rays emitted from the stepper (not shown).

Fig. 7B depicts heat treatment of the wafer 23 at a temperature about 100°C carried out, following the first exposing step, in a heating furnace containing an ammonia gas atmosphere. Such treatment lowers the dissolubility of a portion 22A of the resist, which was exposed in the first exposing step, and therefore the exposed portion becomes less likely to dissolve into a developing solution.

Fig. 7C shows the second exposing step in which the entire surface of the resist film 22 is exposed once again by the irradiation light mainly containing the g rays using the same stepper as before. After this step, the unexposed portion 22B, which was not exposed in the first exposing step, becomes dissolvable.

Fig. 7D illustrates a resist pattern with an excellent resist profile, having a desired taper shape with its opening sized about the same as the corresponding mask, obtained through a development process using a general alkaline developing solution such as tetramethyl ammonium (TMAH).

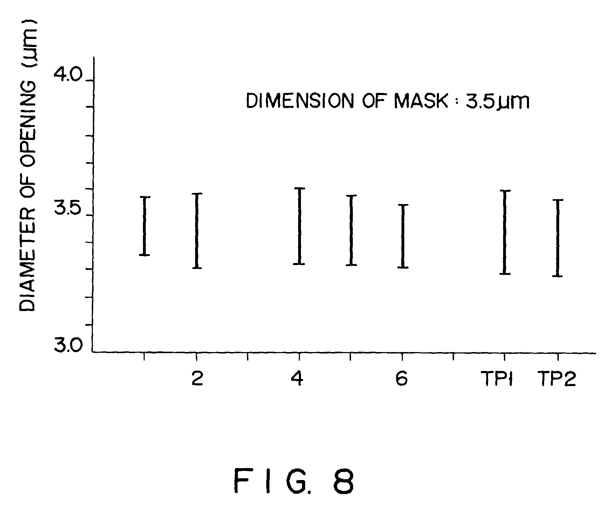

Fig. 8 shows the graphed results of experiments in which seven wafers with the wiring pattern whose mask dimension is 3.5 micron were consecutively processed by the first embodiment of the present invention method. In the graph, the abscissa indicates numbers assigned to the wafers to distinguish with each other, and the ordinate indicates the diameter (µm) of an opening of a resist. Further, each of the vertical lines plotted in the graph exhibits the distribution of the opening diameters of a plurality of samples formed in each of the wafers. The short horizontal lines plotted at both upper and lower ends of each vertical line indicates the maximum and minimum diameters, respectively, of the openings of each wafer.

As can be seen from Fig. 8, the dispersions of the measurements of the openings, regardless of whether it is within each wafer or between wafers, with respect to the 3.5 µm mask dimension were ±0.2 µm or less. This means that the patterning according to the invention produces patterns having substantially the same dimension as that of the corresponding mask. Further, the taper angle (θ in Fig. 7) between the resist profile and the bottom of the resist is about 85°, and over-corrosion of the tapered-shaped portion or residue on the bottom of the resist, which were the problems of the conventional technique, were not found.

When a lift-off step was carried out using a resist pattern thus obtained, wiring metal having the thickness of about 4000 Å could be easily lifted off.

Moreover, regarding a wiring pattern having the line width of 2 µm, the results were similar to the case of 3.5 µm mask dimension.

In addition, the above embodiment is, of course, not limited to use of a novolak-type positive resist, but a novolak-type negative resist capable of image reversion also can be used.

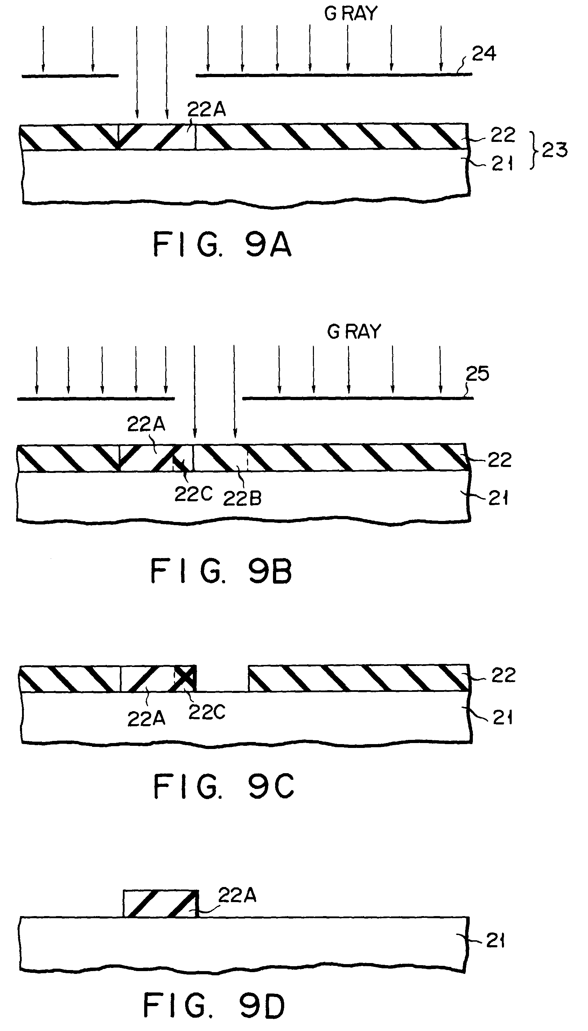

The second embodiment of the present invention will now be explained with reference to Figs. 9A to 9D. This embodiment is, as the first embodiment, a case where the invention is applied to a method of forming a resist pattern used in the lift-off method.

Fig. 9A shows a wafer 23 prepared by applying a novolak-type positive resist on a GaAs substrate 21 to form a resist film 22. In this case also, the resist may be applied indirectly to the substrate via an interlayer insulation film deposited therebetween. Then, the first exposing step is conducted, in which a selected portion of the resist film 22 is exposed, using a mask 24, to the g rays emitted as indicated by the arrows from the stepper (not shown).

After that, the wafer 23 is heat treated at a temperature about 100°C carried out in a heating furnace (not shown) containing an ammonia gas atmosphere, and the second exposing step is conducted, in which another selected portion 22B of the resist film 22 is exposed, using a mask 25 having a different pattern from that of the mask 24, to the g rays emitted as indicated by the arrows from the same stepper. This mask 25 has a pattern having an opening adjacent to that of the patterns of the mask 24 used on the first exposing step. Fig. 9B shows a case in which displacement of the mask 24, which should have been aligned to the determined position, occurred during the second exposing step. Ideally, the portion 22A exposed first and the portion 22B exposed later should not overlap with each other. However, in this case, the portion 22A and portion 22B partially overlap with each other.

At completion of the second exposing step, the portion 22B of the resist, which was exposed in this step, has become dissoluble. However, the overlapping portion 22C of the portion 22A with the portion 22B has lower dissolubility as that of the portion 22A against the developing solution.

Consequently, when development is carried out, the portion 22B, excluding the portion 22C, is removed, and therefore all of the portion 22A exposed in the first step remains unremoved. Following this, treatments using the remaining resist film 22 after the above step as a mask, such as introduction of impurities to the substrate 21, and etching of the substrate, etc. are conducted.

Then, the second exposing step in which the entire surface of the resist film 22 is exposed once again by the irradiation light mainly containing the g rays using the same stepper as before. After this step, when development is performed, the entire resist film except for the portion 22A is removed.

As described, in this embodiment, a selected portion of the resist film 22 can be exposed during the second exposing step. When the portion exposed during the second exposing step is located too adjacent to the portion exposed in the first exposing step, these portions may overlap with each other due to drift of the second exposure. Even in such a case, there is no problem as described above, according to this embodiment.

To summarize, according to the present invention, there is provided a method of manufacturing a semiconductor device, in which when forming a resist pattern using an image reversal treatment, the resist profile is formed into a taper shape advantageous for a lift-off step, and formed so that the profile is of the 1 : 1 ratio in terms of dimension with respect to the corresponding mask.

## Claims

1. A process for forming an image, comprising:
the step of forming a positive resist film on a semiconductor substrate, the positive resist film containing a novolak resin;
a first selective exposing step for forming an image pattern on a selected first region of said resist film with irradiation light mainly comprising g-ray light having a wavelength of 436 nm;
a heat treatment step for heating said resist film after said first exposing step;
a second selective exposing step for exposing said resist film with irradiation light mainly comprising g-ray light having a wavelength of 436 nm to form an image pattern on a selected second region of said resist film;
a first developing step for developing said resist film to remove a region of said resist film exposed in said second selective exposing step and not exposed in said first exposing step;
a third exposing step for exposing the entire surface of said resist film; and
a second developing step for developing said resist film to remove the resist film except for a region exposed in said first selective exposing step.

2. A process according to claim 1, wherein said heat treatment step is conducted in an ammonia gas atmosphere.

3. A process according to claim 1 or 2, wherein said third exposing step is conducted with irradiation light of g-ray light having a wavelength of 436 nm.

4. A process according to any preceding claim, wherein said semiconductor substrate is made of GaAs.

5. A process for forming a semiconductor device in which the steps of the image forming process of any preceding claim are performed.

## Patentansprüche

1. Verfahren zur Erzeugung eines Bildes mit folgenden Schritten:
einem Schritt der Herstellung einer Positiv-Resistschicht auf einem Halbleitersubstrat, wobei die Positiv-Resistschicht ein Novolack-Harz enthält;
einem ersten selektiven Belichtungsschritt zur Erzeugung eines Bildmusters auf einem ausgewählten ersten Bereich der Resistschicht durch Bestrahlung mit Licht, das hauptsächlich g-Strahlung mit einer Wellenlänge von 436 nm umfaßt;
einem Wärmebehandlungsschritt zur Erwärmung der Resistschicht nach dem ersten Belichtungsschritt;
einem zweiten selektiven Belichtungsschritt zur Bestrahlung der Resistschicht mit Licht, das hauptsächlich g-Strahlung mit einer Wellenlänge von 436 nm umfaßt, um auf einem ausgewählten zweiten Bereich der Resistschicht ein Bildmuster herzustellen;
einem ersten Entwicklungsschritt zur Entwicklung der Resistschicht, um einen Bereich der Resistschicht zu entfernen, der im zweiten selektiven Belichtungsschritt jedoch nicht im ersten selektiven Belichtungsschritt belichtet wurde;
einem dritten Belichtungsschritt zur Belichtung der ganzen Oberfläche der Resistschicht und
einem zweiten Entwicklungsschritt zur Entwicklung der Resistschicht, um die Resistschicht mit Ausnahme eines Bereiches, der im ersten selektiven Belichtungsschritt belichtet wurde, zu entfernen.

2. Verfahren nach Anspruch 1, bei welchem der Wärmebehandlungsschritt in einer Ammoniak-Atmosphäre durchgeführt wird.

3. Verfahren nach Anspruch 1 oder 2, bei welchem der dritte Belichtungsschritt mittels g-Strahlung mit einer Wellenlänge von 436 nm durchgeführt wird.

4. Verfahren nach einem der vorhergehenden Ansprüche, bei welchem das Halbleitersubstrat aus GaAs besteht.

5. Verfahren zur Herstellung eines Halbleiterbauelements, bei welchem die Schritte des Bilderzeugungsverfahrens nach einem der vorhergehenden Ansprüche durchgeführt werden.

## Revendications

1. Procédé de formation d'une image, comprenant :
une étape de formation d'un film d'un matériau de réserve positive sur un substrat semi-conducteur, le film du matériau de réserve positive contenant une résine novolaque,
une première étape d'exposition sélective destinée à former un motif d'image sur une première région choisie du film du matériau de réserve avec de la lumière d'irradiation contenant essentiellement de la lumière de rayons g ayant une longueur d'onde de 436 nm,
une étape de traitement thermique destinée à chauffer le film du matériau de réserve après la première étape d'exposition,
une seconde étape d'exposition sélective destinée à l'exposition du film du matériau de réserve avec de la lumière d'irradiation contenant essentiellement de la lumière de rayons g ayant une longueur d'onde de 436 nm pour la formation d'un motif d'image sur une seconde région choisie du film du matériau de réserve,
une première étape de développement du film de matériau de réserve, avec extraction d'une région du film du matériau de réserve exposé dans la seconde étape d'exposition sélective et non exposé dans la première étape d'exposition,
une troisième étape d'exposition de l'ensemble de la surface du film de matériau de réserve, et
une seconde étape de développement du film du matériau de réserve afin que le film du matériau de réserve soit retiré sauf dans une région exposée dans la première étape d'exposition sélective.

2. Procédé selon la revendication 1, dans lequel l'étape de traitement thermique est réalisée en atmosphère d'ammoniac gazeux.

3. Procédé selon la revendication 1 ou 2, dans lequel la troisième étape d'exposition est réalisée avec de la lumière d'irradiation de rayons g ayant une longueur d'onde de 436 nm.

4. Procédé selon l'une quelconque des revendications précédentes, dans lequel le substrat semi-conducteur est formé de GaAs.

5. Procédé de formation d'un dispositif à semi-conducteur, dans lequel les étapes du procédé de formation d'image de l'une quelconque des revendications précédentes sont exécutées.
